(19) **Europäisches Patentamt / European Patent Office / Office européen des brevets**

(11) **EP 1 878 039 B1**

(12) # EUROPÄISCHE PATENTSCHRIFT

(45) Veröffentlichungstag und Bekanntmachung des Hinweises auf die Patenterteilung:
**04.03.2009 Patentblatt 2009/10**

(21) Anmeldenummer: **06721937.8**

(22) Anmeldetag: **28.04.2006**

(51) Int Cl.:
**H01J 37/32** *(2006.01)* **C23C 16/26** *(2006.01)*

(86) Internationale Anmeldenummer:
**PCT/CH2006/000235**

(87) Internationale Veröffentlichungsnummer:
**WO 2006/116889 (09.11.2006 Gazette 2006/45)**

(54) **PLASMAVERSTÄRKER FÜR PLASMABEHANDLUNGSANLAGE**

PLASMA AMPLIFIER FOR PLASMA TREATMENT PLANT

AMPLIFICATEUR DE PLASMA POUR UNE INSTALLATION DE TRAITEMENT AU PLASMA

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **04.05.2005 CH 788052005**

(43) Veröffentlichungstag der Anmeldung:
**16.01.2008 Patentblatt 2008/03**

(73) Patentinhaber: **Oerlikon Trading AG, Trübbach 9477 Trübbach (CH)**

(72) Erfinder:
- **MASSLER, Orlaw**
  **FL-9492 Eschen (LI)**
- **EBERLE, Hubert**
  **FL-9495 Triesen (LI)**
- **GSCHWEND, Patrick**
  **CH-9475 Sevelen (CH)**

(74) Vertreter: **Kreutz, Thomas J.**
**Troesch Scheidegger Werner AG**
**Schwäntenmos 14**
**CH-8126 Zumikon (CH)**

(56) Entgegenhaltungen:
| | |
|---|---|
| EP-A- 0 727 508 | EP-A- 1 619 265 |
| WO-A-01/79585 | DE-A1- 19 826 259 |
| DE-B- 1 161 864 | US-A1- 2002 000 779 |

- OKS E M ET AL: "A high-current ion source based on a hollow-cathode glow discharge with e-beam injection" HIGH-POWER PARTICLE BEAMS, 1998. BEAMS '98. PROCEEDINGS OF THE 12TH INTERNATIONAL CONFERENCE ON HAIFA, ISRAEL 7-12 JUNE 1998, PISCATAWAY, NJ, USA, IEEE, US, Bd. 2, 7. Juni 1998 (1998-06-07), Seiten 955-958, XP010369281 ISBN: 0-7803-4287-9

## Beschreibung

### Technisches Gebiet

Die Erfindung betrifft einen Plasmaverstärker für eine Plasmabehandlungsanlage gemäss dem Oberbegriff des Anspruchs 1, insbesondere für den Einsatz in einer Vakuumbeschichtungsanlage nach Anspruch 15, bzw. für eine Vakuumbehandlungsverfahren nach Anspruch 18.

### Stand der Technik

Es sind Heiss- oder Kaltkathoden bekannt, bei welchen durch Anlegen einer Spannung zwischen einer Kathode, beispielsweise einer Glühwendel oder einer Spitze mit hohem negativen Potential, und einer Anode Elektronen in den Behandlungsraum einer Vakuumbeschichtungsanlage extrahiert werden um dort die Dichte der Ladungsträger zu erhöhen. Solche Elektronenquellen bzw. Ionenquellen sind mit einer eigenen elektrischen Versorgung versehen. Die Kathode steht dabei üblicherweise nur über eine Blende mit dem Behandlungsraum der Plasmabehandlungsanlage in Verbindung, um beispielsweise die Belastung der Kathode durch Reaktivgas oder andere negative Einflüsse durch den Plasmabehandlungsprozess zu vermeiden. Nachteilig ist dabei einerseits, dass die Elektronen ausserhalb der Beschichtungskammer erzeugt werden und somit weitere Vorrichtungen notwendig sind um diese möglichst verlustfrei in die Behandlungskammer zu überführen, andererseits können auf Grund der zusätzlich notwendigen elektrischen Versorgung und aufwendiger Bauweise schon aus Kostengründen nur eine geringe Anzahl solcher Elektronen- bzw. Ionenquellen vorgesehen werden. Meist ist d.h. wenn überhaupt nur eine derartige Ionenquelle an einer Plasmabehandlungsanlage vorgesehen.

Bekannte Verfahren zur Abscheidung von DLC-Schichten, d.h. Schichten mit einem hohen Anteil an $sp^3$-Kohlenstoffbindungen wie beispielsweise in WO 01/79585 beschrieben, nutzen eine Mittelfrequenzanregung auf dem Substrat, um durch die entstehende Glimmentladung eine Schichtabscheidung zu erzeugen. Die Glimmentladung wird zwischen den Bauteilen und der Anlagenwand mittels eines DC-, bzw. mittel eines unipolar oder bipolar gepulsten Substratbias im Druckbereich herkömmlicher Magnetron-Sputterabscheidung erzeugt.

Dabei werden die zu beschichtenden Bauteile aktiv in den Prozess einbezogen. Die erzielbare Abscheiderate wird dadurch unter anderem stark von der Geometrie der Anordnung zur Werkstückbeschichtung in der Beschichtungsanlage bestimmt, was eine starke Schwankung in der Abscheiderate bewirkt. Dadurch kann die Situation entstehen, dass bei einer wenig aktiven Anordnung eine schwache Ionisierung entsteht. Dies führt zu einer geringen Abscheiderate und damit niedrigen Produktivität.

In bekannten Plasmabehandlungsanlagen werden Werkstücke auf Substratträgern gehalten, z. B. in Form eines Karussels und an den/der Beschichtungsquelle(n) vorbeigeführt. Beispiele dafür sind 2-fach rotierende Anordnungen ohne geometrische Abstände im Bereich von 20-80 mm, wodurch keine kontrollierte Plasma-Hohlkathode erzeugt wird. Typisches Problemfeld ist die Beschichtung von Plattenanordnungen und flachen Teilen, welche nur einen geringen Plasmastrom erzeugen.

Eine weitere Vorrichtung zum Zünden eines Glimmentladungsplasmas zur Beschichtung eines Werkstücks ist in der Druckschrift EP 1 619 265 gezeigt, die unter Artikel 54(3) EPÜ fällt.

Eine Erhöhung des Kohlenstoffangebots durch eine Erhöhung des Reaktivgas-Flusses ist im Allgemeinen durch die Saugleistung des Vakuumpumpsystems nur in begrenztem Ausmass möglich, da beim Verlassen des optimalen Prozessfensters die Schichtqualität kompromittiert wird.

### Darstellung der Erfindung

Der Erfindung liegt die Aufgabe zu Grunde, einen Plasmaverstärker zur Verfügung zu stellen, der ohne aufwendige zusätzliche Massnahmen in den Plasmabehandlungsraum bzw. direkt auf einem Karussell oder sogar in einem Werkstückträger integriert eingebaut werden kann.

Diese Aufgabe wird durch die erfindungsgemässen Merkmale im kennzeichnenden Teil des Anspruchs 1 gelöst. Damit kann der Plasmaverstärker durch eine Biasversorgung zum Anlegen eines elektrischen Signals an die Werkstücke betrieben werden.

Von herkömmlichen Plasmaprozessen ist bekannt, dass abhängig von Prozessdruck und anliegender Spannung durch bestimmte geometrische Anordnungen ein oder mehrere Nebenplasmen durch den so genannten Hohlkathodeneffekt entstehen können. Diese Nebenplasmen mit einer zwar lokal begrenzten aber sehr hohen Plasmadichte stören den geplanten Plasmaprozess durch verschieden Effekte wie Überhitzung einzelner Substrate, Plasmaschwankungen, Graphitisierung in der Gasphase und anderes, weshalb bei allen üblichen Plasma-CVD-Verfahren Vorkehrungen getroffen werden, um solche Nebenplasmen zu vermeiden.

Überraschenderweise ist es durch eine erfindungsgemäss ausgeführte Vorrichtung gelungen den Hohlkathodeneffekt ohne schädliche Auswirkungen auf Prozessführung bzw. Schichtqualität, durch einen Plasmaverstärker mit einer von den Prozessparametern abhängigen, empirisch bestimmbaren Geometrie so zu nutzen, dass eine stabile Steigerung der Plasmadichte und eine signifikante Steigerung der Abscheiderate möglich ist.

Die erfindungsgemässe Vorrichtung zum Verstärken und/oder Zünden eines Glimmentladungsplasmas umfasst dabei zumindest einem Hohlkörper aus elektrisch leitfähigem Material, wobei der Hohlraum des Hohlkörpers so ausgebildet ist, dass bei Anlegen eines elektrischen Signals an den Hohlkörper zumindest in einem bestimmten Druck- und Spannungsbereich die geometrischen Bedingungen zum Zünden einer Entladung im Inneren des Hohlkörpers erfüllt sind. Weiters umfasst der Hohlkörper zumindest eine Öffnung durch die Ladungsträger in die Umgebung der Vorrichtung abfliessen können um dort das Zünden und Betreiben eines Plasmas zu ermöglichen oder ein dort bestehendes Plasma zu verstärken.

Die erfindungsgemässe Vorrichtung ist eine Vorrichtung zur Behandlung, insbesondere zur Beschichtung von Werkstücken, wobei die Werkstücke mit dem Hohlkörper nicht identisch sind.

Dabei wird die Geometrie so gewählt, dass die Prozess-Temperatur niedrig gehalten werden kann um die Eigenschaften der Werkstücke nicht zu beeinflussen. Entscheidend für die Geometrie des im Wesentlichen zumindest einen Hohlraum umfassenden Plasmaverstärkers sind dabei die Innenabmessungen bzw. ein charakteristischer geometrischer Parameter des Hohlraums, der eine Kennzahl für den mittleren Abstand der den Hohlraum umgebenden Flächen gleichen elektrischen Potentials darstellt. Beispielsweise hat sich für einen Druckbereich von 1x $10^{-3}$ mbar bis 5x $10^{-2}$ mbar, bevorzugt 4x $10^{-3}$ mbar bis 2x $10^{-2}$ mbar ein mittlerer Abstandsbereich von 20 bis 200 mm, bevorzugt 60 bis 100 mm als geeignet herausgestellt.

Die Anwendung dieses Prinzip kann dadurch erfolgen, dass zumindest eine erfindungsgemässe Vorrichtung als Plasmaverstärker in die Beladung eines Karussells mit Werkstückträgern eingebaut wird, wodurch im gesamten Behandlungsraum die Plasmadichte erhöht und beispielsweise eine höhere Abscheiderate erzielt werden kann.

Alternativ dazu können die Werkstücke direkt auf einer erfindungsgemässen Vorrichtung befestigt werden und kommen damit direkt mit dem Plasma der Hohlkathode in Verbindung. Auch Kombinationen unterschiedlicher Ausführungen der erfindungsgemässen Vorrichtung können vorteilhaft eingesetzt werden.

Im Folgenden wird der Versuch unternommen, die der Erfindung zu Grunde liegenden Phänomene an Hand bekannter physikalischer Gesetzmässigkeiten zu erklären. Dies kann jedoch nur als eine, möglicherweise auch mit Fehlern behaftete Annäherung an die in einer industriellen Beschichtungsanlage vorliegenden Verhältnisse angesehen werden. Diese können sich beispielsweise in Bezug auf dabei auftretende komplexe Geometrien oder bewegte Elektroden wesentlich von den an Hand modellhafter, vereinfachter Annahmen entwickelten Modellen unterscheiden.

Unter der Annahme, dass eine erfindungsgemässe Vorrichtung zur Verstärkung des Plasmas, die entweder aus einem oder mehreren Plasmaverstärkerbäumchen bzw. aus Substratbäumchen entsprechender Geometrie besteht, stellen diese eine Kathode für eine Glimmentladung dar, wobei die Anode die Beschichtungskammer ist, die bevorzugt auf Erdpotential liegt. Zum Zünden der Glimmentladung wird eine Spannung zwischen Anode und Kathode angelegt, die zwischen 200 V und 2000 V, bevorzugt zwischen 400 V und 1200 V, jeweils einschliesslich der Grenzwerte, beträgt. Nach dem Zünden kann die Entladung auch mit einer niedrigeren Spannung betrieben werden.

Die Zündung des Plasmas folgt dabei dem Gesetz von Paschen. Nach diesem Gesetz ist die Zündspannung $V_t$, bzw. das Zündpotential $E_t$ gasartabhähgig und bei gegebener Gasart eine Funktion des Produkts aus Elektrodenabstand d und Druck p:

$$V_t = [B \times p \times d] / [C + \ln pd], \quad E_t = B / [C + \ln pd] ;$$

Mit B und C als gasartenabhängigen Konstanten.

Wie dem Fachmann bekannt, gibt es verschiedene Möglichkeiten den Zündvorgang zu verbessern, so kann beispielsweise bei Anlegen einer Gleichspannung diese kurzfristig mit hohen Frequenzen gepulst werden. Unabhängig von der Art der Betreiberspannung, die eine Gleich-, eine bipolare- oder unipolare Puls-, eine herkömmliche Wechselspannung oder auch eine modulierte Gleichspannung umfassen kann, wird das Zünden eines erfindungsgemässen Plasmaverstärkers durch folgende Massnahmen beeinflusst bzw. verbessert:

- rasche Druckschwankungen,
- kurzfristige Spannungserhöhung (einzelner Spannungspuls),
- gepulster Betrieb der Spannungsquelle,
- das Anlegen eines externen Magnetfelds senkrecht oder parallel zur Kathoden/Anoden Entladungsstrecke,
- zusätzliches Betreiben eines Plasmas beispielsweise in Form eines Sputter-, Funken- oder Niedervoltbogenplasmas,
- Auswahl eines gut ionisierbaren Gases wie z.B. Ar, Ne, He.

Der Erhöhung der Plasmadichte mittels Magnetfeld kommt dabei eine besondere Bedeutung zu, da sich damit die Wahrscheinlichkeit für eine Ionisierung des Gases im gesamten Plasmaraum erhöht. Für alle Bedingungen, bei denen die Geschwindigkeit der Ladungsträger im Plasma nicht parallel zum Magnetfeld ist, treten Kräfte auf, die diese Ladungsträger auf kreisförmige Bahnen zwingen. Im verhältnismässig kleinen Kathodenfallgebiet wird die Bewegung der Ladungsträger wegen der verhäitnismässig grossen Feldstärken nur wenig beeinflusst. Dagegen wirkt das Magnetfeld stärker auf die positive Säule. Die Kräfte des Magnetfeldes verringern die Abdiffusion der Ladungsträger und erhöhen die Plasmadichte durch die erhöhte Stosswahrscheinlichkeit mit den Gasmolekülen.

Dem erfindungsgemässen Plasmaverstärker liegt im Wesentlichen der Effekt der Erhöhung der Plasmadichte durch Zünden einer Hohlkathode zu Grunde. Wenn eine Entladung so betrieben wird, dass einer Anode mehrere Kathoden zugeordnet werden, spielt der Abstand der Kathoden zueinander eine Rolle. Sind die Abstände der Kathoden voneinander grösser als der doppelte Kathodenfall, kommt es zu keiner gegenseitigen Beeinflussung. Nähert man die Kathoden einander oder verkleinert man die Gasdichte, so treten schnellere Elektronen von der einen Kathodenoberfläche in das Kathodenfallgebiet der anderen Kathode ein und werden dabei durch die ebenfalls negative Ladung abgebremst und reflektiert. Diese Reflexion an den Kathodenpotentialen geht solange vonstatten, bis das Elektron Energie, beispielsweise durch Stoss, verloren hat. Durch die Reflexion erhöht sich wiederum die Ionisierungswahrscheinlichkeit. Die Stromdichte steigt an und kann sich in Abhängigkeit von der Gasart, des Drucks, des Abstands bzw. der Geometrie um einen Faktor von mehr als Hundert erhöhen.

Bei sehr kleinem Abstand der Kathoden voneinander fällt die Stromdichte jedoch wieder rasch ab, was damit begründet wird, dass der Strom aus dem Spalt zwischen den beiden Kathoden seinen Weg zur Anode nicht mehr findet.

Die gegenseitige Beeinflussung der Kathoden wird als Hohlkathodenwirkung bezeichnet. Sie bildet sich aus, wenn eine Kathode Hohlräume aufweist, die einen Durchmesser kleiner als der doppelte Fallraum aufweisen. Die Grösse des Kathodenfallraums kann dabei stark durch das Anlegen eines Magnetfelds beeinflusst werden.

Bis heute wurde in herkömmlichen Plasmabehandlungslagen bzw. Elektrodenanordnungen das Entstehen von Hohlkathoden insbesondere in unmittelbarer Nähe der zu behandelnden Oberfläche möglichst vermieden, da sich durch die Ausbildung solcher so genannten Nebenplasmen im allgemeinen sehr negative Effekte für den Plasmabehandlungsprozess ergeben. Beispielsweise kann durch solche Entladungen Energie aus dem Plasma abgezogen, das Reaktivgas zu rasch oder zu vollständig zersetzt oder die Werkstückoberflächen überhitzt werden, um nur einige der störenden Phänomene zu beschreiben.

Ein Ziel der vorliegenden Erfindung ist es hingegen einen Plasmaverstärker zur Verfügung zu stellen, der die nachteiligen Wirkungen einer Hohlkathode vermeidet und die Plasmadichte innerhalb und ausserhalb des Plasmaverstärkers in einem solchen Mass erhöht, dass sie zur Verbesserung des Behandlungsprozesses beiträgt. Dabei ist die Plasmadichte im Inneren wesentlich höher, was für eine bessere Zerlegung bzw. Anregung von gasförmigen Precursor vorteilhaft ist.

Anhand der folgenden Zeichnungen soll das Prinzip der Erfindung beispielhaft beschrieben werden. Dabei zeigt

Figur 1    einen Plasmaverstärker
Figur 2    einen Werkstückträger
Figur 3    ein Karussell

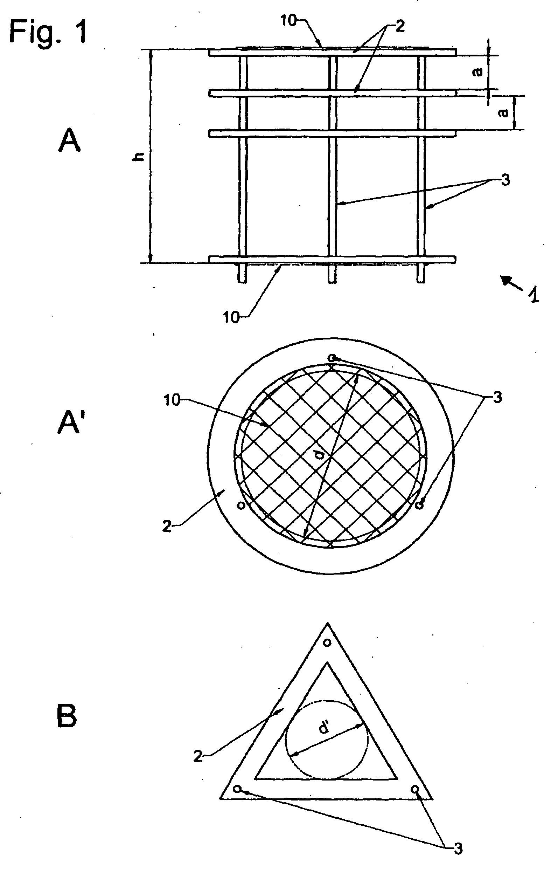

Der in Fig.1 dargestellte Plasmaverstärker 1, ist aus mehreren übereinander angeordneten Kreis-, Ellipsen- oder Vieleckringen 2 oder Ringen zusammengesetzter Geometrien aufgebaut, wobei die Ringe 2 in einem Abstand a, angeordnet sind, der klein genug ist um ein Zünden einer Hohlentladung zwischen den Ringen 2 zu vermeiden. Wird der Abstand nur geringfügig zu gross gewählt kommt es zu einem Zünden eines sehr intensiven unerwünschten Nebenplasmas zwischen den parallel angeordneten Kathoden 2, mit den oben beschriebenen nachteiligen Folgen.

Abstand a zwischen den Kathodenringen 2, bzw. Abstand b zwischen den Werkstücken bzw. Halterungen muss somit klein gegenüber dem doppelten Kathodenfall, vorteilhaft sogar kleiner als der Kathodenfall sein. In der vorliegenden Ausführung wurde ein Abstand a von 1 bis 60 mm, bevorzugt 5 bis 25 mm gewählt.

Die Gesamthöhe h des Plasmaverstärkers 1 kann dabei leicht durch Hinzufügen oder Weglassen eines oder mehrere Ringe 2 variiert werden. Die Ringe 2 können beispielsweise durch einzelne Verbindungsstäbe 3 mit hier nicht näher gezeigten Distanzhülsen in der gewünschten Lage gehalten werden.

Der geometrisch charakteristische Parameter im Falle der vorliegenden Fig.1A, A' ist der innere Durchmesser d der Kathodenringe der auch die wesentliche Dimension zur Generierung und Stabilisierung der Hohlkathode darstellt. In Fig.1B wird der Durchmesser d' des Dreieckinkreises als charakteristischer Parameter angenommen. Der Durchmesser d, d' sollte daher so gewählt werden, dass die Bedingungen für eine Hohlkathode erfüllt sind, d.h. kleiner oder ungefähr gleich dem doppelten Kathodenfall. In der vorliegenden Ausführung wurde ein Abstand d von 20 bis 200 mm, bevorzugt zwischen 60 und 100 mm gewählt. Gemeinsam mit der Höhe h definiert somit Durchmesser d, d' die Geometrie der Hohlkathode, die nicht nur in unterschiedlicher Geometrie des Querschnitts ausgeführt sondern auch durch unterschiedlicher Begrenzungsflächen gegenüber dem übrigen Plasmaraum abgegrenzt werden kann. Beispielsweise können statt vieler Ringsegmente 2 nur ein oberes und ein unteres Ringsegment mit einem dazwischen gespannten Gitter oder parallelen Drähten bzw. Stangen, Zylinder oder andere Hohlkörper mit geeigneten Öffnungen bzw. Ausnehmungen am Umfang beispielsweise in Form von Schlitzen oder Ähnlichem vorgesehen werden. Wichtig ist, dass es zumindest eine Öffnung der Hohlkathode gibt, die den Ladungsträgern den Weg zur Anode offen hält.

In der in Fig.1 gezeigten Ausführung hat sich weiters gezeigt, dass eine Abdeckung der oberen, bzw. unteren Öffnung durch ein Metallgitter 10 die Stabilität des Plasmas positiv beeinflussen kann.

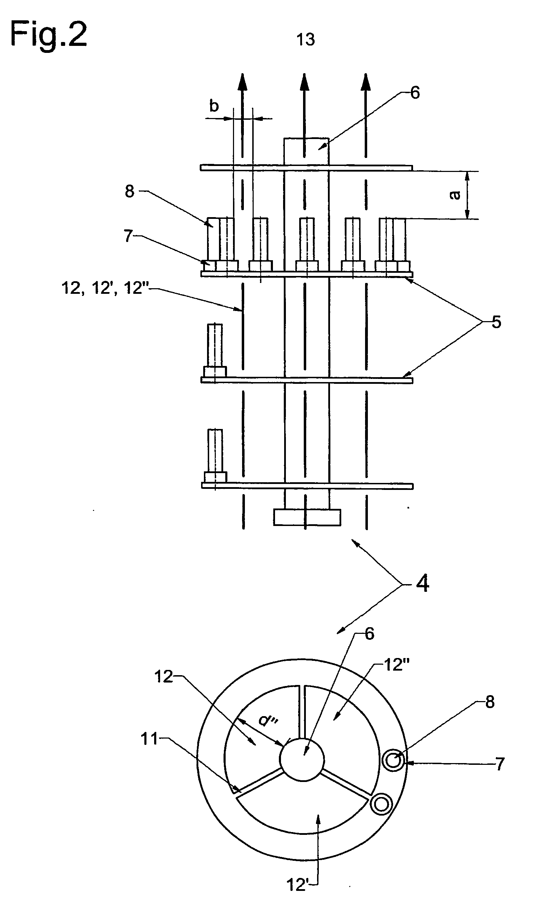

Fig. 2 zeigt einen Werkstückträger 4, der als Plasmaverstärker ausgeführt ist, dabei sind die Ringe 5 mit Aufnahmen 7 für Werkstücke 8 ausgeführt sind. Der charakteristische Parameter d" kann hier entweder wie dargestellt als kleinster Abstand des Werkstückträgers 5 zu einer Trägerstange 6, oder als kleinster Abstand zwischen den Speichen 11 des Werkstückträgers angesehen werden, je nachdem, welcher Abstand kleiner ist. Auch hier ist es wesentlich, dass der Abstand a, sowie die Abstände b zwischen den Werkstücken 8, so gewählt werden, das es zu keinem Zünden einer Hohlkathodenentladung kommt. Daher sollten zumindest die Werkstücke einer Werkstückträgerebene sehr ähnliche oder besser gleiche Geometrien aufweisen oder durch zusätzliche Massnahmen die entsprechenden Abstände a bzw. b eingestellt werden. Um ein möglichst gleichmässiges Hohlentladungsplasma über die Höhe des Plasmaverstärkers 4 zu erzielen ist es vorteilhaft die Speichen 11 der jeweiligen Werkstückträgerringe 5 in derselben Position vorzusehen, sodass wie beispielsweise in dem in Fig. 2 dargestellten Fall drei identische Hohlkathodenräume 12, 12', 12" im Inneren des Plasmaverstärkers 4 gebildet werden.

Prinzipiell kann bereits ein einziger Werkstückträgerring 5 mit einem Hohlkathodenraum 12, oder ein einzelner Ring 2 als Plasmaverstärker eingesetzt werden, sofern die für den entsprechenden Druck-/Spannungsbereich geeignet Geometrie gewählt wird. Es versteht sich allerdings für den Fachmann von selbst, dass entsprechende wie in Fig.1 oder 2 dargestellte aus mehreren Ebenen von Ringen 2 bzw. von Werkstückträgerringen 5 bestehende Plasmaverstärker 1 bzw. als Plasmaverstärker ausgeführte Werkstückträger 4 eine wesentlich stärkere Wirkung erzielen. Beispielsweise kann in solchen Plasmaverstärkern 1, 4 sehr effizient Reaktivgas oder Precursor für Plasma-CVD-, bzw. kombinierte PVD/CVD-Prozesse angeregt bzw. aufgespalten und in hochreaktive Spezies, beispielsweise ionisierte Moleküle, Molekülfragmente und/oder in Radikale übergeführt werden. Damit wird auch die Abscheiderate wesentlich erhöht und bei geeigneter Prozessführung die Schichtqualität solcher Plasma-CVD-Schichten verbessert.

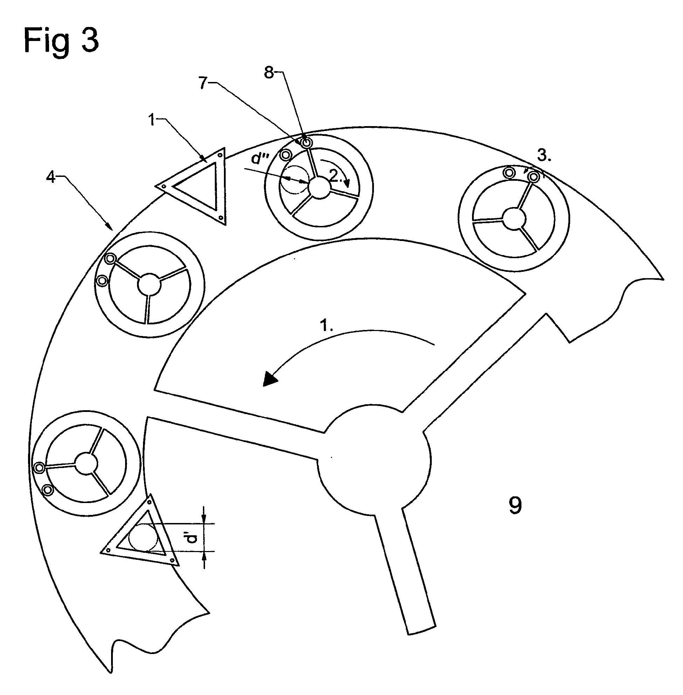

In Fig. 3 ist ein Karussell 9 dargestellt, auf dem sowohl mehrere Plasmaverstärker 1, wie in Fig. 1 dargestellt, als auch mehrere Werkstückträger 4, wie in Fig. 2 ausgeführt, angebracht sind. Die Werkstückträger 4 können dabei drehbeweglich montiert sein und beispielsweise wie dargestellt im Zusammenwirken mit Karussell 9 und Aufnahmen 7 eine Dreifachrotation der Werkstücke 8 bewirken, um eine möglichst gleichmässige Beschichtungsqualität zu erzielen. Eine solche Dreifachrotation wird durch die entsprechenden Bewegungspfeile 1., 2. und 3. schematisch dargestellt. Vorteilhaft ist dabei, wenn der charakteristische geometrische Abstand d' des Plasmaverstärker 1 zumindest etwas kleiner als der charakteristische geometrische Abstand d" des Werkstückträgers 4 ist, wodurch bei Anlegen eines beispielsweise mittelfrequenten Pulssignals gemäss der Paschengleichung zunächst das Plasma in den Plasmaverstärkern gezündet wird.

Besonders vorteilhaft ist eine solche Anordnung, wenn beispielsweise von einer metallischen Haftschicht ausgehend, ein graduierter Übergang zu einer DLC-Schicht erzeugt werden soll. Wird die Haftschicht zunächst aus reinem Metall beispielsweise Cr oder Ti, wobei wie dem Fachmann bekannt auch andere Metalle der IV, V, oder VI Nebengruppe des Periodensystems der Elemente bzw. Si oder Al in Frage kommen, durch ein Sputter-, ein Arc-, ein Niedervoltbogen- oder ein anderes PVD-Verfahren aufgebracht und anschliessend ein kohlenstoffhaltiges Gas, beispielsweise Acetylen, Methan, Ethan, Ethylen oder ähnliches, zugegeben bildet sich eine im wesentlichen Metall und Metallkarbid enthaltende Mischschicht. Es kommt jedoch nicht oder kaum zur Ausbildung $sp^3$-haltiger Kohlenstoffstrukturen solange lediglich ein DC-Bias anliegt, da in diesem Fall das Reaktivgas in einem zu geringem Ausmass angeregt bzw. durch das Plasma zerlegt wird. Wird jedoch beispielsweise ein Mittelfrequenzpulssignal an das Karussell 9 angelegt, zündet das Hohlkathodenplasma auf Grund des kleineren Abstandes d, d' zunächst in den Plasmaverstärkern 1. Das Zünden wird durch jede zusätzliche Plasmaquelle, beispielsweise durch die Glimmentladung der Sputtertargets und bei Bedarf durch ein zusätzliches senkrecht zur Hohlkathodenebene angelegtes Magnetfeld erleichtert. Dies kann beispielsweise durch eine dem Fachmann bekannte Helmholtzanordnungen zweier Magnetspulen an einer Beschichtungsanlage erzeugt werden.

Nach Zünden des Hohlkathodenplasmas in den Plasmaverstärkern 1, kommt es durch den Mehrverbrauch des Reativgases zu einer Druckabsenkung, die ein rasches Zünden eines weiteren Hohlkathodenplasmas in den Hohlräumen 12, 12', 12" der Werkstückträger 4 und eine weitere Verarmung an Reaktivgas zur Folge hat. Die Zündung des Plasmas in den Werkstückträgern 4 erfolgt dabei durch den bereits hohen Anteil an Ladungsträgern aus den Plasmaverstärkern 1 völlig synchron und ohne Plasmaschwankungen. Wird nun der Reaktivgasanteil erhöht, was vorteilhafterweise in Form einer beispielsweise rampenartigen Erhöhung des Reaktivgasflusses geschieht, steht an der Oberfläche der Werkstoffe ein hoher Anteil hochangeregter Kohlenstoff- bzw. Kohlenstoffwasserstoffionen zur Verfügung die den Aufbau $sp^3$-haltiger Strukturen ermöglichen. Je nach Prozessführung können nun metallhaltige $sp^3$-Strukturen oder, beispielsweise durch Zurückregeln oder Abblenden der Targets, im Wesentlichen nur aus Kohlenstoff und Wasserstoff bestehende $sp^3$-Strukturen abgeschieden werden. Ein weiterer Vorteil ergibt sich bei Verwendung derartiger Plasmaverstärker 1 bzw. Werkstückträger 4 dadurch, dass der Prozess so geführt werden kann, dass auch bei Abscheidung von isolierenden, beispielsweise DLC-Schichten auf den Werkstücken, die Leitfähigkeit auf der Innenseite des Plasmaverstärkers 1 bzw. des Werkstückträgers 4 erhalten bleibt. Dies ergibt sich auf Grund der in diesem Bereich erhöhten Temperaturbelastung bzw. auf Grund des erhöhten Beschusses mit ionisierten Teilchen, die beispielsweise bei Verwendung eines kohlenstoffhaltigen Reaktivgases eine Graphitisierung auf der Innenfläche des Hohlkörpers bzw. der Hohlkathode bewirkt.

Im Folgenden werden an Hand von Beispielen der Unterschied zum Stand der Technik und die vorteilhafte Wirkung des Einsatzes erfindungsgemässer Plasmaverstärker aufgezeigt. Details zu den Prozessparametern und geometrischer Ausführung der Vorrichtung finden sich in Tabelle 1. Der Prozess wurde auf einem Karussell mit 6 bzw. 12 Bäumchen durchgeführt.

Beispiel 1

Hier werden die Werkstücke auf Bäumchen gemäss dem Stand der Technik chargiert, so, dass eine Hohlkathode vermieden wird. Der Substratstrom im Prozess ist gering, die Beschichtungsrate ist niedrig.

Beispiel 2

Hier werden die Teile auf Bäumchen chargiert, die einer erfindungsgemässen Vorrichtung entsprechen. Dadurch wird bei Anlegen eines MF-Bias eine Hohlkathode gezündet und eine Erhöhung des Substratstroms sowie eine im Vergleich zu Beispiel 1 erhöhte Abscheiderate erreicht. Die geometrischen Parameter der Hohlentladung wurden so an die Prozessparameter angepasst, dass die Teile weder überhitzt noch die Schichtqualität negativ beeinflusst wurde.

Beispiel 3

Hier werden die Werkstücke wie in Beispiel 1 chargiert, zusätzlich wurden 2 von 12 Bäumchen durch eine wie in Fig. 1 beschriebene Vorrichtung ersetzt. Alternativ wurden auf einem mit 6 Bäumchen beladenen Karussell zusätzlich 3 Plasmaverstärker 1 wie in Fig. 3 eingesetzt. In beiden Fällen zeigte sich eine positive Beeinflussung der Abscheiderate.

Beispiel 4

Hier werden die Teile auf einer Vorrichtung wie in Beispiel 2 chargiert, die Hohlkathode wird mit einem höherem Druck betrieben, was eine zusätzliche Erhöhung des Substratstroms und der Abscheiderate verglichen mit Beispiel 1 und 2 zur Folge hat. Auch unter diesen Bedingungen, wurden die Teile weder überhitzt noch die Schichtqualität negativ beeinflusst.

Beispiel 5

Hier wurden die Abstände grösser als in Beispiel 1, aber kleiner als in Beispiel 2 gewählt. Offensichtlich entspricht hier d'' einem mittleren Abstand im Bereich einer maximalen Elektronenreflexion da hier die Hohlkathode sehr intensiv brennt, die Teile überhitzt werden und eine schlechte Schichtqualität durch Graphitisierung erzeugt wird.

Beispiel 6

Zeigt eine deutliche Abhängigkeit der Wirkung des Plasmaverstärkers von der Frequenz des angelegten elektrischen Signals. Bei einer Frequenzerhöhung von 50 auf 100 kHz konnte bei im Übrigen konstanten Parametern eine gegenüber Beispiel 4 wesentliche Erhöhung des Substratstroms und der Beschichtungsrate erzielt werden.

Wiewohl im Vorhergehenden viele verschiedene Möglichkeiten zur Ausführung der Erfindung dargestellt wurden, ist es dem Fachmann an Hand der Beschreibung klar, dass es noch viele andere Möglichkeiten gibt, entsprechende Vorrichtungen zum Zünden oder Verstärken des Plasmas zu verwirklichen. Beispielsweise kann eine entsprechende Vorrichtung auch an der Vakuumkammer, den Kammerboden oder Kammerdeckel anstatt auf dem Karussell angebracht werden, sofern die Vorrichtung vom Rezipienten isoliert und ein entsprechendes elektrisches Signal, beispielsweise das Substratbiassignal, angelegt wird.

Tabelle 1: Beispiele zur Erfindung

| | Beispiel 1: Stand der Technik | Beispiel 2: Aufbau mit 3-fach rotierenden Teilen auf der Vorrichtung | Beispiel 3: Aufbau mit zusätzlichen Vorrichtungen ohne Beladung | Beispiel 4: Aufbau mit 3-fach rotierenden Teilen auf der Vorrichtung | Beispiel 5: Ausbau auf Vorrichtung mit zu kleinen Abständen | Beispiel 6: Aufbau mit 3-fach rotierenden Teilen auf Vorrichtung |
|---|---|---|---|---|---|---|
| Reaktivgasfluss | 220 - 320 sccm | 220 - 350 sccm | 220 - 350 sccm | 350 - 500 sccm | 220 -350 sccm | 350 -500sccm |
| Arbeitsdruck | 5.0-7.0 $10^{-3}$ mbar | 5.0 - 7.0 $10^{-3}$ mbar | 5.0-7.0$10^{-3}$ mbar | 7.0-1.2$10^{-2}$ mbar | 4.5-7.0 $10^{-3}$ mbar | 7.0-1.2 $10^{-3}$ mbar |
| Abstand d" Werkstück Halterungsoberfläche | 10 mm | 60-100mm | 10 mm | 60-100 mm | 40 mm | 60-100mm |
| Beladesituation | Plattenwerkstück, sowie 3 fache Rotation,:10 Werkstücke auf einem Teller | 3 fache Rotation; 40 Werkstücke auf einem Teller | Plattenwerkstück, sowie 3 fache Rotation, wie Beispiel 1 | 3 fache Rotation; 30 Werkstücke auf einem Teller | 3 fache Rotation; 30 Werkstücke auf einem Teller | 3 fach Rotation; 30 Werkstücke auf einem Teller |
| Anzahl der Bäum-chen | 12 | 6 | 6 | 12 | 12 | 6 |
| Amplitudenspan-nung | -800 -1000V | -800 -1000V | -800 -1000V | -800 -1000V | -800 -1000V | -800v - -1000V |
| Substratstrom | 0.5 - 1.5A | 1.5 - 4.0 A | 1.5-4.0 A | 2.0 - 6.0A | 2 - 20A instabil | 4.0 - 12A |
| Signalfrequenz | 50 kHz | 50 kHz | 50 kHz | 50 kHz | 50 kHz | 100 kHz |
| Abscheiderate | 0.2 $\mu$m/h | 0.9$\mu$m/h | 0.9 $\mu$m/h | 1.5$\mu$m/h | ---------- | 2.0 - 2.5$\mu$m/h |
| Temparatur Bauteil | 200°C | 200°C | 200-250°C | >250°C | >250°C | - 250°C |

**Patentansprüche**

1. Vorrichtung (1,4) zum Verstärken und/oder Zünden eines Glimmentladungsplasmas, zur Behandlung, insbesondere zur Beschichtung von Werkstücken (8), mit zumindest einem Hohlkörper (2,5) aus elektrisch leitfähigem Material, wobei der Hohlraum des Hohlkörpers (2,5) so ausgebildet ist, dass bei Anlegen eines elektrischen Signals an den Hohlkörper (2,5) zumindest in einem bestimmten Druck- und Spannungsbereich die geometrischen Bedingungen zum Zünden einer Entladung im Inneren des Hohlkörpers (2,5) erfüllt sind, und der Hohlkörper (2,5) zumindest eine Öffnung umfasst, durch die Ladungsträger in die Umgebung der Vorrichtung abfliessen können, um dort das Zünden und Betrieb eines Plasmas zu ermöglichen oder ein dort bestehendes Plasma zu verstärken, und wobei die Werkstücke (8) mit dem Hohlkörper (2,5) nicht identisch sind, **dadurch gekennzeichnet, dass** die Vorrichtung (1,4) Mittel umfasst, die den Hohlkörper (2,5) elektrisch mit den Werkstücken (8) verbinden, so dass der Hohlkörper (2,5) im wesentlichen auf Werkstückpotential liegt.

2. Vorrichtung (1,4) gemäss Anspruch 1, **dadurch gekennzeichnet, dass** der Hohlkörper (2,5) auf einem Karussell (9) zur Aufnahme von Werkstückträgern (4) befestigt ist.

3. Vorrichtung (1,4) nach Anspruch 1, **dadurch gekennzeichnet, dass** die geometrischen Bedingungen für einen Druckbereich zwischen $1 \times 10^{-3}$ bis $5 \times 10^{-2}$ mbar, bevorzugt zwischen $4 \times 10^{-3}$ bis $2 \times 10^{-2}$ mbar erfüllt sind.

4. Vorrichtung (1,4) nach Anspruch 1, **dadurch gekennzeichnet, dass** die geometrischen Bedingungen für ein elektrisches Signal mit einem Spannungsbereich zwischen 200 bis 2000 V, bevorzugt zwischen 400 bis 1200 V erfüllt sind.

5. Vorrichtung (1,4) nach Anspruch 3, **dadurch gekennzeichnet, dass** das elektrische Signal ein Gleichspannungs-, ein Wechselspannungs-, insbesondere ein bipolar oder unipolar gepulstes Wechselspannungssignal im Mittelfrequenzbereich ist.

6. Vorrichtung (1,4) nach Anspruch 1, **dadurch gekennzeichnet, dass** der Hohlkörper (2,5) eine Höhe h und einen Querschnitt mit zumindest einem geometrisch charakteristischen Parameter d besitzt, wobei der Querschnitt die Form eines Kreises, einer Ellipse eines Mehrecks oder eine aus unterschiedlichen Geometrien zusammengesetzte Form hat, und der Hohlkörper (2,5) mindestens eine sich über die Höhe h erstreckende Seitenfläche umfasst.

7. Vorrichtung (1,4) nach Anspruch 6, **dadurch gekennzeichnet, dass** der Hohlkörper (2,5) oben und/oder unten mit einem Gitter abgedeckt ist.

8. Vorrichtung (1,4) nach Anspruch 6, **dadurch gekennzeichnet, dass** die Seitenfläche des Hohlkörpers (2,5) mehrere Öffnungen oder Schlitze über seine Höhe h aufweist.

9. Vorrichtung (1,4) nach Anspruch 6, **dadurch gekennzeichnet, dass** die mindestens eine Seitenfläche des Hohlkörpers (2,5) Gitter oder parallele Drähte bzw. Stangen umfasst bzw. im Wesentlichen aus einem Gitter oder parallelen Drähte bzw. Stangen besteht.

10. Vorrichtung (1,4) nach Anspruch 6, **dadurch gekennzeichnet, dass** der Hohlkörper (2,5) mehrere übereinander angeordneten Kreis-, Ellipsen-, Vieleckringe oder Ringe zusammengesetzter Geometrien umfasst, wobei die Ringe (2) in einem Abstand a, angeordnet sind, der klein genug ist um ein Zünden einer Hohlentladung zwischen den Ringen (2) zu vermeiden.

11. Vorrichtung (1,4) nach Anspruch 10, **dadurch gekennzeichnet, dass** dass Abstand a kleiner als der Kathodenfall in einem bestimmten Druck- und Spannungsbereich, insbesondere zwischen 1 bis 60 mm, bevorzugt zwischen 5 bis 25 mm ist.

12. Vorrichtung (1,4) nach Anspruch 10, **dadurch gekennzeichnet, dass** die Ringe als Werkstückhalter mit Aufnahmen (7) ausgebildet sind, wobei die Aufnahmen (7) bzw. die Werkstücke (8) zueinander in einem Abstand b angeordnet sind, der klein genug ist um ein Zünden einer Hohlentladung zwischen den Werkstückaufnahmen (7) bzw. den Werkstücken (8) zu vermeiden.

13. Vorrichtung (1,4) nach Anspruch 12, **dadurch gekennzeichnet, dass** Abstand a und/oder b kleiner als der Kathodenfall in einem bestimmten Druck- und Spannungsbereich, insbesondere zwischen 1 bis 60 mm, bevorzugt zwischen 5 bis 25 mm ist.

**14.** Vorrichtung (1,4) nach Anspruch 6 oder 12, **dadurch gekennzeichnet, dass** Parameter d kleiner oder gleich dem doppelten aber grösser oder gleich dem einfachen Kathodenfall in einem bestimmten Druck- und Spannungsbereich, insbesondere zwischen von 20 bis 200 mm, bevorzugt zwischen 60 und 100 mm ist.

**15.** Vakuumbehandlungsanlage zur Plasmabehandlung, insbesondere zur Plasmabeschichtung von Werkstücken (8) **dadurch gekennzeichnet, dass** sie eine Vorrichtung (1,4) gemäss einem der vorhergehenden Ansprüche umfasst.

**16.** Vakuumbehandlungsanlage nach Anspruch 15, **dadurch gekennzeichnet, dass** die Anlage eine zusätzliche Magnetfelderzeugungsvorrichtung umfasst die auf die Hohlkathodenentladungsstrecke wirkt bzw. das Plasma verstärkt.

**17.** Vakuumbehandlungsanlage nach Anspruch 16, **dadurch gekennzeichnet, dass** durch die Magnetfelderzeugungsvorrichtung ein Magnetfeld 13 herstellbar ist, dass senkrecht auf die Hohlkathodenentladungsstrecke wirkt.

**18.** Vakuumbehandlungsverfahren, **dadurch gekennzeichnet, dass** eine Vorrichtung (1,4) gemäss einem der Ansprüche 1 bis 14 zum ein Zünden und in Betrieb halten eines Plasmas oder zur Verstärkung eines bereits bestehenden Plasma verwendet wird.

**19.** Vakuumbehandlungsverfahren nach Anspruch 18, **dadurch gekennzeichnet, dass** die Vorrichtung (1,4) verwendet wird um Reaktivgas oder Precursor für einen Plasma-CVD-Prozess bzw. für eine kombinierten PVD/CVD-Prozesse anzuregen bzw. aufzuspalten.

**Claims**

**1.** Arrangement (1,4) for boosting and/or igniting a glow discharge plasma, for the treatment, in particular for the coating, of workpieces (8), with at least one hollow body (2,5) of an electrically conductive material, wherein the hollow space of the hollow body (2,5) is such, that when an electric signal is applied to the hollow body (2,5) at least in a certain pressure and voltage range the geometric conditions for the ignition of a discharge in the interior of the hollow body (2,5) are satisfied, and the hollow body (2,5) comprises at least one opening through which charge carriers can flow off into the environs of the arrangement in order to make here possible the ignition and operation of a plasma or to boost a plasma existing here, and wherein the workpieces (8) are not identical with the hollow body (2,5), **characterized in that** the arrangement (1,4) comprises means which connect the hollow body (2,5) electrically with the workpieces (8) such that the hollow body (2,5) is essentially at workpiece potential.

**2.** Arrangement (1,4) according to claim 1, **characterized in that** the hollow body (2,5) is fastened on a carousel (9) for the reception of workpiece carriers (4).

**3.** Arrangement (1,4) according to claim 1, **characterized in that** the geometric conditions are satisfied for a pressure range between $1 \times 10^{-3}$ to $5 \times 10^{-2}$ mbar, preferably between $4 \times 10^{-3}$ to $2 \times 10^{-2}$ mbar.

**4.** Arrangement (1,4) according to claim 1, **characterized in that** the geometric conditions for an electric signal are satisfied with a voltage range between 200 to 2000 V, preferably between 400 to 1200 V.

**5.** Arrangement (1,4) according to claim 3, **characterized in that** the electric signal is a DC voltage, an AC voltage, in particular a bipolar or unipolar pulsed AC voltage signal in the medium frequency range.

**6.** Arrangement (1,4) according to claim 1, **characterized in that** the hollow body (2,5) has a height h and a cross section with at least one geometrically characteristic parameter d, wherein the cross section has the form of a circle, an ellipse, a polygon or a form composed of different geometries, and the hollow body (2,5) comprises at least one lateral face extending over the height h.

**7.** Arrangement (1,4) according to claim 6, **characterized in that** the hollow body (2,5) is covered at the top and/or at the bottom with a grid.

**8.** Arrangement (1,4) according to claim 6, **characterized in that** the lateral face of the hollow body (2,5) has several openings or slots over its height h.

**9.** Arrangement (1,4) according to claim 6, **characterized in that** the at least one lateral face of the hollow body (2,5) comprises grids or parallel wires or rods, or essentially consists of a grid or parallel wires or rods.

10. Arrangement (1,4) according to claim 6, **characterized in that** the hollow body (2,5) comprises several circular, elliptical, polygonal annuli or annuli of combined geometries, disposed one above the other, wherein the annuli (2) are disposed at a distance a, which is sufficiently small to avoid the ignition of a hollow discharge between the annuli (2).

11. Arrangement (1,4) according to claim 10, **characterized in that** the distance a is smaller than the cathode drop in a certain pressure and voltage range, in particular is between 1 to 60 mm, preferably between 5 to 25 mm.

12. Arrangement (1,4) according to claim 10, **characterized in that** the annuli are formed as workpiece holders with receptions (7), wherein the receptions (7) or the workpieces (8) are disposed with respect to one another at a distance b, which is sufficiently small to avoid the ignition of a hollow discharge between the workpiece receptions (7) or the workpieces (8).

13. Arrangement (1,4) according to claim 12, **characterized in that** distance a and/or b is smaller than the cathode drop in a certain pressure and voltage range, in particular is between 1 to 60 mm, preferably between 5 to 25 mm.

14. Arrangement (1,4) according to claim 6 or 12, **characterized in that** parameter d is less or equal to the twofold, however greater or equal to the simple cathode drop in a certain pressure and voltage range, in particular is between 20 to 200 mm, preferably between 60 and 100 mm.

15. Vacuum treatment installation for plasma treatment, in particular for the plasma coating of workpieces **characterized in that** it comprises an arrangement (1,4) according to one of the preceding claims.

16. Vacuum treatment installation according to claim 15, **characterized in that** the installation comprises an additional magnetic field generating device, which acts on the hollow cathode discharge gap or boosts the plasma.

17. Vacuum treatment installation according to claim 16, **characterized in that** through the magnetic field generating device a magnetic field (13) is producible, that acts perpendicularly onto the hollow cathode discharge gap.

18. Vacuum treatment method, **characterized in that** an arrangement (1,4) according to one of claims 1 to 14 is utilized for the ignition and maintaining in operation of a plasma or for boosting an already existing plasma.

19. Vacuum treatment method according to claim 18, **characterized in that** the arrangement (1,4) is utilized in order to excite or split reactive gas or precursors for a plasma CVD process or for a combined PVD/CVD process.


**Revendications**

1. Dispositif (1, 4) pour l'amplification et/ou l'allumage d'un plasma à décharge lumineuse, pour le traitement, en particulier pour le revêtement de pièces (8), avec au moins un corps creux (2, 5) en un matériau conducteur de l'électricité, où l'espace creux du corps creux (2, 5) est formé de sorte que lors de l'imposition d'un signal électrique sur le corps creux (2, 5), au moins dans un certain intervalle de pression et de tension, les conditions géométriques pour l'allumage d'une décharge à l'intérieur du corps creux (2, 5) sont remplies, et le corps creux (2, 5) comprend au moins une ouverture, par laquelle des porteurs de charge peut s'écouler dans l'environnement du dispositif pour y permettre l'allumage et le fonctionnement d'un plasma ou pour l'amplification d'un plasma y existant, et où les pièces (8) ne sont pas identiques au corps creux (2, 5), **caractérisé en ce que** le dispositif (1, 4) comprend un moyen qui relie le corps creux (2, 5) électriquement aux pièces (8) de sorte que le corps creux (2, 5) se trouve essentiellement au potentiel des pièces.

2. Dispositif (1, 4) selon la revendication 1, **caractérisé en ce que** le corps creux (2, 5) est fixé sur un carrousel (9) pour la réception de supports de pièce (4).

3. Dispositif (1, 4) selon la revendication 1, **caractérisé en ce que** les conditions géométriques sont remplies pour un intervalle de pression allant de $1 \times 10^{-3}$ à $5 \times 10^{-2}$ mbar, de préférence de $4 \times 10^{-3}$ à $2 \times 10^{-2}$ mbar.

4. Dispositif (1, 4) selon la revendication 1, **caractérisé en ce que** les conditions géométriques sont remplies pour un signal électrique avec un intervalle de tension allant de 200 à 2000 V, de préférence de 400 à 1200 V.

5. Dispositif (1, 4) selon la revendication 3, **caractérisé en ce que** le signal électrique est un signal à tension continue, un signal à tension alternative, en particulier un signal à tension alternative pulsée bipolaire ou unipolaire dans la gamme des fréquences moyennes.

6. Dispositif (1, 4) selon la revendication 1, **caractérisé en ce que** le corps creux (2, 5) possède une hauteur h et une coupe avec au moins un paramètre caractéristique d, où la coupe a la forme d'un cercle, une ellipse, un polygone ou une forme composée de différentes géométries, et le corps creux (2, 5) comprend au moins une surface latérale s'étendant sur la hauteur h.

7. Dispositif (1, 4) selon la revendication 6, **caractérisé en ce que** le corps creux (2, 5) est couvert en haut et/ou en bas d'une grille.

8. Dispositif (1, 4) selon la revendication 6, **caractérisé en ce que** la surface latérale du corps creux (2, 5) présente plusieurs ouvertures ou fentes sur sa hauteur h.

9. Dispositif (1, 4) selon la revendication 6, **caractérisé en ce que** la au moins une surface latérale du corps creux (2, 5) comprend une grille ou des fils ou tiges parallèles et respectivement, consiste essentiellement en une grille ou des fils ou tiges parallèles.

10. Dispositif (1, 4) selon la revendication 6, **caractérisé en ce que** le corps creux (2, 5) comprend plusieurs d'anneaux superposées de cercle, d'ellipse, de polygone ou d'une forme des géométries composées, où les anneaux (2) sont agencés à une distance a, qui est assez petit pour éviter un allumage d'une décharge cruese entre les anneaux (2).

11. Dispositif (1, 4) selon la revendication 10, **caractérisé en ce que** la distance a est inférieure à la chute cathodique dans un intervalle donné de pression et de tension, et se situe en particulier entre 1 et 60 mm, de préférence entre 5 et 25 mm.

12. Dispositif (1, 4) selon la revendication 10, **caractérisé en ce que** les anneaux sont formés comme des supports de pièce avec réceptions (7), où les réceptions (7) et respectivement, les pièces (8) sont agencées à une distance b l'une de l'autre, qui est suffisamment petit pour éviter un allumage d'une décharge cruese entre les réceptions de pièce (7) et respectivement, les pièces (8).

13. Dispositif (1, 4) selon la revendication 12, **caractérisé en ce que** la distance a et/ou b est inférieure à la chute cathodique dans un intervalle donné de pression et de tension, et se situe en particulier entre 1 et 60 mm, de préférence entre 5 et 25 mm.

14. Dispositif (1, 4) selon la revendication 6 ou 12, **caractérisé en ce que** le paramètre d est inférieur ou égal au double de, mais supérieur ou égal à la chute cathodique dans un intervalle donné de pression et de tension, et se situe en particulier entre 20 et 200 mm, de préférence entre 60 et 100 mm.

15. Installation de traitement sous vide pour le traitement par plasma, en particulier pour le revêtement par plasma de pièces (8), **caractérisée en ce qu'**elle comprend un dispositif (1,4) selon l'une des revendications précédentes.

16. Installation de traitement sous vide selon la revendication 15, **caractérisée en ce que** l'installation comprend un dispositif supplémentaire de génération d'un champ magnétique, qui agit sur l'étendue de la décharge cruese cathodique et respectivement, amplifie le plasma.

17. Installation de traitement sous vide selon la revendication 16, **caractérisée en ce que** par le dispositif de génération d'un champ magnétique, on peut former un champ magnétique 13, qui agit perpendiculairement à l'étendue de la décharge cruese cathodique.

18. Procédé de traitement sous vide, **caractérisée en ce que** l'on utilise un dispositif (1,4) selon l'une des revendications 1 à 14 pour l'allumage et le maintien en fonctionnement d'un plasma ou pour amplifier un plasma déjà présent.

19. Procédé de traitement sous vide selon la revendication 18, **caractérisée en ce que** le dispositif (1, 4) est utilisé pour exciter ou cliver un gaz réactif ou précurseur pour un processus plasma-CVD ou un processus PVD/CVD combiné.

# Fig. 1

A

A'

B

## Fig.2

13

6

b

8

a

7

12, 12', 12"

5

4

6

12"

12

d"'

8

11

7

12'

# Fig 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0179585 A
- EP 1619265 A